# EUROPEAN PATENT SPECIFICATION

(11) **EP 2 716 793 B1**
(45) Date of publication and mention of the grant of the patent: **10.04.2019**
(21) Application number: 12792865.3
(22) Date of filing: 29.05.2012
(51) Int. Cl.: C23C 18/20, H05K 1/03, H05K 3/18, C08L 63/00, C08L 77/00

(54) **PRIMER LAYER FOR PLATING PROCESS, LAMINATE FOR CIRCUIT BOARD AND PRODUCTION METHOD FOR SAME, AND MULTILAYER CIRCUIT BOARD AND PRODUCTION METHOD FOR SAME**
GRUNDIERUNGSSCHICHT FÜR EIN PLATTIERUNGSVERFAHREN, BESCHICHTUNG FÜR EINE LEITERPLATTE UND HERSTELLUNGSVERFAHREN DAFÜR SOWIE MEHRSCHICHTIGE LEITERPLATTE UND HERSTELLUNGSVERFAHREN DAFÜR
COUCHE DE PRIMAIRE POUR UN PROCÉDÉ DE PLAQUAGE, STRATIFIÉ POUR UNE CARTE DE CIRCUIT IMPRIMÉ ET SON PROCÉDÉ DE FABRICATION, ET CARTE DE CIRCUIT IMPRIMÉ MULTI-COUCHES ET SON PROCÉDÉ DE FABRICATION

(30) Priority: 31.05.2011 JP 2011122794
(43) Date of publication of application: 09.04.2014
(73) Proprietor: Hitachi Chemical Co., Ltd., Chiyoda-ku Tokyo 100-6606 (JP)
(72) Inventor: FUJIMOTO, Daisuke, Chikusei-shi Ibaraki 308-0861 (JP); YAMADA, Kunpei, Chikusei-shi Ibaraki 308-0861 (JP); OGAWA, Nobuyuki, Chikusei-shi Ibaraki 308-0861 (JP); MURAI, Hikari, Chikusei-shi Ibaraki 308-0861 (JP)
(74) Representative: Hoffmann Eitle
(86) International application number: PCT/JP2012/063790
(87) International publication number: WO 2012/165439

(56) References cited:
- EP-A1- 1 300 444
- WO-A1-2008/072630
- JP-A- 2001 233 945
- JP-A- 2011 086 729

## Description

### FIELD OF THE INVENTION

The present invention relates to a primer layer for plating process, a laminate for wiring board having the primer layer and a method for manufacture thereof, and a multilayer wiring board having the primer layer and a method for manufacture thereof.

### RELATED ART

It was general that a multilayer wiring board is manufactured in the following method. That is, first of all, a material (prepreg) prepared by impregnating a glass cloth with an epoxy resin and forming in a semi-cured state is superimposed on an insulating substrate having an internal layer circuit formed on one surface or both surfaces thereof together with a copper foil, followed by lamination and integration by a heat press. Thereafter, a hole for interlayer connection, which is called a through-hole, is bored using a drill. An inner wall of the through-hole and a surface of the copper foil are subjected to electroless plating, and if desired, electroplating is further performed, thereby allowing the plated layer as a circuit conductor to have a necessary thickness. Then, unnecessary copper is removed to manufacture a multilayer wiring board.

In recent years, downsizing, weight reduction and multi-functionalization of electronic appliances made remarkable progress, and following this, high integration of LSI and chip components has been advanced. And a configuration thereof rapidly changes toward high pin-count and downsizing. For that reason, in multilayer wiring boards, in order to enhance a mounting density of an electronic component, the development of fine wiring is advanced. For realization of fine wiring, in order to increase adhesiveness between a copper foil and a resin, it is effective to make the roughness of the copper foil small by a roughening treatment. This is because by making the roughness of the copper foil small, it becomes easy to remove the unnecessary copper foil. For that reason, correspondence has been made by using a low-profile copper foil having a small roughness by a roughening treatment, or a primer-provided non-roughened copper foil in which in order to secure an adhesive force to a resin, a primer resin is introduced into a non-roughened copper foil having not been subjected to a roughening treatment (see Patent Document 1) .

But, such correspondence was insufficient for achieving more fine wiring because the copper foil to be removed is thick.

Then, in order to cope with this requirement of fine wiring, a multilayer wiring board of a build-up mode in which an insulating resin not containing a glass cloth is used as an insulating layer in place of the prepreg, and a wiring layer is formed while connecting only a necessary portion by a via hole has been frequently used. Such a multilayer wiring board of a build-up mode is also useful from the standpoints of weight reduction and downsizing.

In such a multilayer wiring board of a build-up mode, for example, an insulating resin film is laminated on an internal layer circuit board; after curing by heating, a via hole is formed by means of laser processing; and a roughening treatment and a smearing treatment are performed by a treatment with an alkaline permanganate, or the like. Thereafter, electroless copper plating is performed to form a via hole which makes it possible to achieve interlayer connection with a second circuit, thereby manufacturing a multilayer wiring board of a build-up mode (see Patent Documents 2 to 4).

Here, a circuit forming method which is chiefly adopted for multilayer wiring boards of a build-up mode as in Patent Documents 2 to 4 is a semi-additive method. According to this method, after electroless copper plating, only a necessary portion is subjected to electrolytic copper plating to form a circuit, and thereafter, an electroless copper plated layer existing in an unnecessary portion is removed. This method is more advantageous for fine wiring than the conventional methods because the electroless copper plated layer to be removed is thin, and this method is the mainstream of the current fine wiring forming method. According to this method, it is the situation that an adhesive force between the resin and the electroless copper plating is secured by a roughness of the resin surface (anchor effect), and it was the situation that the surface roughness is large as 0.5 µm or more in terms of Ra.

In multilayer wiring boards, following downsizing and high density of semiconductor packages in recent years, more fineness of a circuit is required. Under such a situation, according to the conventional methods of securing an adhesive force to the electroless copper plating by utilizing a large roughened shape obtained by roughening the surface (anchor effect), there is a concern that fine circuits of not more than 10 µm cause short circuit failure or open failure. For that reason, multilayer wiring boards cannot be manufactured in a good yield. On the other hand, if the roughened shape is made small, the adhesive force to the electroless copper plating is lowered, and a failure such as separation of a line is generated. For that reason, a wiring board material having a smooth surface and exhibiting a high adhesive force to the electroless copper plating became necessary.

Also, for the purpose of securing good adhesiveness between the electroless copper plating and the resin, there is proposed an insulating film having a double-layered structure of an adhesive layer containing an electroless copper plating catalyst and an insulating resin layer (see Patent Document 5). But, this insulating film does not aim to make the roughened shape of the surface smooth, so that it was not sufficient as a substrate for semiconductor package capable of coping with the wiring fineness in recent years.

On the other hand, following thinning of electronic components, the thickness of a wiring board to be used is becoming thin. As a result, in the case where an insulating resin not containing a glass cloth is used as an insulating layer in place of the prepreg, there was a concern that a warp at the time of mounting becomes large, leading to a lowering of the connection reliability. Then, the prepreg containing a glass cloth has been again reviewed. However, there are involved some problems to be solved, such as necessity of high-density wiring by the additive method.

Under such situations, there is proposed a technology of providing a laminate for wiring board with an adhesive auxiliary layer for the purpose of enhancing an adhesive force to an electroless copper plating without relying upon the anchor effect (see Patent Document 6). But, since an adhesive layer is formed by coating an adhesive on the cured laminate, taking into consideration adhesiveness of an interface between the adhesive layer and the laminate, the adhesive layer is required to have a thickness of from 10 to 50 µm, and hence, this technology is not adapted for thinning.

Also, Patent Document 7 proposes an insulating material for a build-up mode, in which an epoxy resin composition containing, as essential components, an epoxy resin, a curing agent, and a phenolic hydroxyl group-containing polyamide. But, in the case of subjecting a build-up substrate fabricated using this material to a peel test by bending at 90°, adhesiveness between the insulating material and copper was not sufficient.

Patent Document 8 discloses an epoxy resin for printed wiring boards, said composition comprising an epoxy resin, an amine curing agent, and a phenolic hydroxyl group-containing polyamide-poly(butadiene-acrylonitrile) block copolymer.

### PRIOR ART DOCUMENTS

### PATENT DOCUMENTS

Patent Document 1: Japanese Patent No. 3949676
Patent Document 2: Japanese Patent No. 3290296
Patent Document 3: Japanese Patent No. 3654851
Patent Document 4: Japanese Patent No. 3785749
Patent Document 5: JP-A-1-99288
Patent Document 6: JP-A-2001-123137
Patent Document 7: JP-A-2001-233945
Patent Document 8: EP 1 300 444 A1

### SUMMARY OF THE INVENTION

### PROBLEMS TO BE SOLVED BY THE INVENTION

As described above, following downsizing of semiconductor packages and high density of wirings, fineness of a circuit is required. Under such situations, according to the method of securing an adhesive force to an electroless copper plating by utilizing a large roughened shape obtained by roughening the surface of a laminate or an insulating layer (anchor effect), if a fine circuit of not more than 10 µm is formed, short circuit failure or open failure is caused, so that manufacture cannot be achieved in a good yield. On the other hand, if the roughened shape is made small, the adhesive force to the electroless copper plating is lowered, and a failure such as separation of a line is generated.

In the light of the above, an object of the present invention is to provide a primer layer for plating process exhibiting high adhesiveness to an electroless copper plating and capable of coping with high density of wirings of semiconductor packages; a laminate for wiring board having the primer layer and a method for manufacture thereof; and a multilayer wiring board having the primer layer and a method for manufacture thereof.

### MEANS FOR SOLVING THE PROBLEMS

In order to solve the foregoing problems, the present inventors made extensive and intensive investigations. As a result, it has been found that a primer layer for plating process which is formed using a resin composition containing a prescribed amount of a phenolic hydroxyl group-containing polybutadiene-modified polyamide resin exhibits high adhesiveness to an electroless copper plating and is capable of coping with high density of wirings of semiconductor packages, leading to accomplishment of the present invention. That is, the present invention is as follows.
[1] A primer layer for plating process formed of a resin composition for primer layer comprising (A) a polyfunctional epoxy resin, (B) an epoxy resin curing agent, and (C) a phenolic hydroxyl group-containing polybutadiene-modified polyamide resin having structural units represented by the following formulae (i), (ii) and (iii), wherein a blending proportion of the phenolic hydroxyl group-containing polybutadiene-modified polyamide resin (C) in the resin composition for primer layer is 5 parts by mass or more and less than 25 parts by mass based on 100 parts by mass of a total sum of the polyfunctional epoxy resin (A) and the epoxy resin curing agent (B). 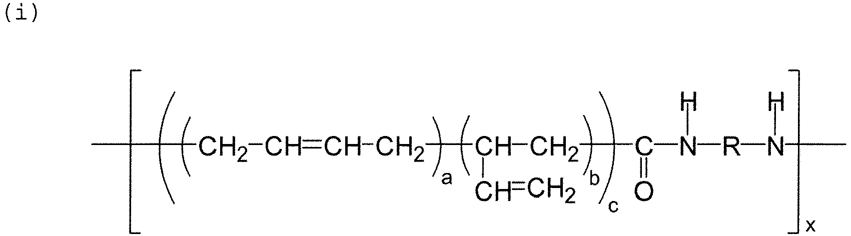 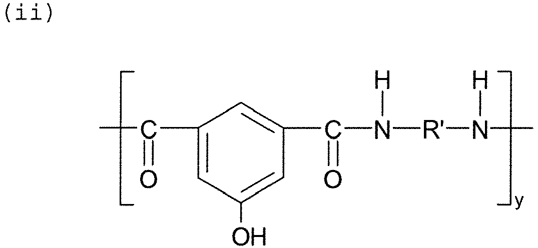 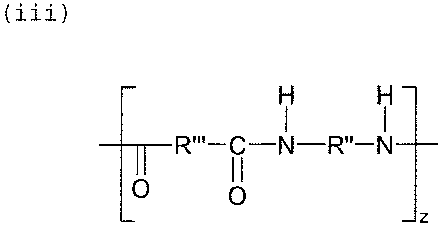
   In the formulae, each of a, b, c, x, y, and z represents an average degree of polymerization; a represents an integer of from 2 to 10; b represents an integer of from 0 to 3; c represents an integer of from 3 to 30; when x is 1, then (y + z) represents an integer of from 2 to 300; when y is 1, then z is 20 or more; each of R, R' , and R" independently represents a divalent group derived from an aromatic diamine or an aliphatic diamine; and each R'" independently represents a divalent group derived from an aromatic dicarboxylic acid, an aliphatic dicarboxylic acid, or an oligomer having a carboxyl group at both ends thereof.
[2] The primer layer for plating process as set forth in [1], having a thickness of from 1 to 10 µm.
[3] The primer layer for plating process as set forth in [1] or [2], wherein the polyfunctional epoxy resin (A) contained in the resin composition for primer layer includes an aralkyl type epoxy resin having a biphenyl structure.
[4] The primer layer for plating process as set forth in any one of [1] to [3], wherein the resin composition for primer layer contains (D) an inorganic filler having an average primary particle diameter of not more than 100 nm.
[5] The primer layer for plating process as set forth in [4], wherein the inorganic filler (D) is fumed silica.
[6] The primer layer for plating process as set forth in [4] or [5], wherein the inorganic filler (D) is subjected to a surface treatment.
[7] The primer layer for plating process as set forth in any one of [1] to [6], wherein a surface roughness (Ra) of the primer layer for plating process after a roughening treatment is not more than 0.4 µm.
[8] A laminate for wiring board provided with a primer layer for plating process, which is obtained by superimposing a primer layer-provided support film having the primer layer for plating process as set forth in any one of [1] to [7] on a support film, on both surfaces of a prepreg for wiring board such that the primer layer for plating process is located inside; further superimposing a mirror board on the outside thereof; press molding them; and after molding, removing the support film.
[9] A method for manufacture of a laminate for wiring board provided with a primer layer for plating process, comprising superimposing a primer layer-provided support film having the primer layer for plating process as set forth in any one of [1] to [7] on a support film, on both surfaces of a prepreg for wiring board such that the primer layer for plating process is located inside; further superimposing a mirror board on the outside thereof; press molding them; and after molding, removing the support film.
[10] A laminate for wiring board provided with a primer layer for plating process, which is obtained by superimposing a primer layer-provided support film having the primer layer for plating process as set forth in any one of [1] to [7] on a support film, on both surfaces of a prepreg for wiring board such that the primer layer for plating process is located inside; laminating them by heating and applying a pressure by a laminator using a heat-resistant rubber sheet; after lamination, curing the laminate by heating; and removing the support film.
[11] A method for manufacture of a laminate for wiring board provided with a primer layer for plating process, comprising superimposing a primer layer-provided support film having the primer layer for plating process as set forth in any one of [1] to [7] on a support film, on both surfaces of a prepreg for wiring board such that the primer layer for plating process is located inside; laminating them by heating and applying a pressure by a laminator using a heat-resistant rubber sheet; after lamination, curing the laminate by heating; and removing the support film.
[12] A multilayer wiring board provided with a primer layer for plating process, which is obtained by superimposing a primer layer-provided support film having the primer layer for plating process as set forth in any one of [1] to [7] on a support film, on a prepreg for wiring board such that the primer layer for plating process is located inside; superimposing the laminate on both surfaces of a circuit-processed wiring board; further superimposing a mirror board on the outside thereof; press molding them; and after molding, removing the support film.
[13] A method for manufacture of a multilayer wiring board provided with a primer layer for plating process, comprising superimposing a primer layer-provided support film having the primer layer for plating process as set forth in any one of [1] to [7] on a support film, on a prepreg for wiring board such that the primer layer for plating process is located inside; superimposing the laminate on both surfaces of a circuit-processed wiring board; further superimposing a mirror board on the outside thereof; press molding them; after molding, removing the support film; and successively applying a roughening treatment, an electroless plating treatment, and an electroplating treatment.
[14] A multilayer wiring board provided with a primer layer for plating process, which is obtained by superimposing a primer layer-provided support film having the primer layer for plating process as set forth in any one of [1] to [7] on a support film, on a prepreg for wiring board such that the primer layer for plating process is located inside; superimposing the laminate on both surfaces of a circuit-processed wiring board; laminating them by heating and applying a pressure by a laminator using a heat-resistant rubber sheet; after lamination, curing the laminate by heating; removing the support film; and successively applying a roughening treatment, an electroless plating treatment, and an electroplating treatment.
[15] A method for manufacture of a multilayer wiring board provided with a primer layer for plating process, comprising superimposing a primer layer-provided support film having the primer layer for plating process as set forth in any one of [1] to [7] on a support film, on a prepreg for wiring board such that the primer layer for plating process is located inside; superimposing the laminate on both surfaces of a circuit-processed wiring board; laminating them by heating and applying a pressure by a laminator using a heat-resistant rubber sheet; after lamination, curing the laminate by heating; removing the support film; and successively applying a roughening treatment, an electroless plating treatment, and an electroplating treatment.

### EFFECTS OF THE INVENTION

According to the present invention, a primer layer for plating process exhibiting high adhesiveness to an electroless copper plating and capable of coping with high density of wirings of semiconductor packages; a laminate for wiring board having the primer layer and a method for manufacture thereof; and a multilayer wiring board having the primer layer and a method for manufacture thereof can be provided.

Also, high solder heat resistance capable of coping with lead-free soldering can be exhibited.

### MODES FOR CARRYING OUT THE INVENTION

### [Primer layer for plating process]

The primer layer for plating process of the present invention is formed of a resin composition for primer layer comprising (A) a polyfunctional epoxy resin (hereinafter also referred to as "component (A)"), (B) an epoxy resin curing agent (hereinafter also referred to as "component (B)"), and (C) a phenolic hydroxyl group-containing polybutadiene-modified polyamide resin having structural units represented by the following formulae (i), (ii) and (iii) (hereinafter also referred to as "component (C)").

(i) 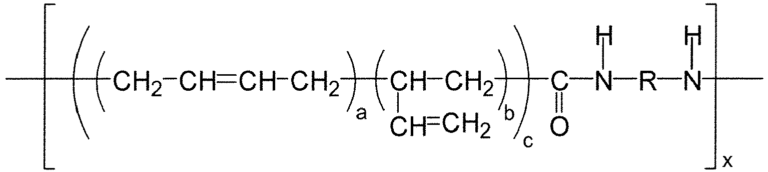
(ii) 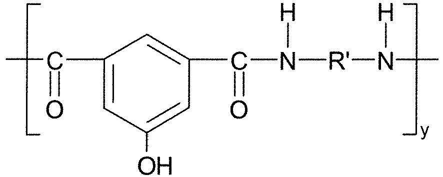
(iii)

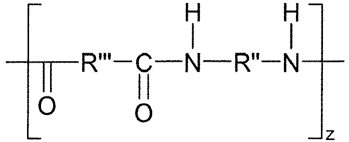

In the formulae, each of a, b, c, x, y, and z represents an average degree of polymerization; a represents an integer of from 2 to 10; b represents an integer of from 0 to 3; c represents an integer of from 3 to 30; when x is 1, then (y + z) represents an integer of from 2 to 300((y+z=x)); when y is 1, then z is 20 or more(z/y); each of R, R', and R" independently represents a divalent group derived from an aromatic diamine or an aliphatic diamine; and each R"' independently represents a divalent group derived from an aromatic dicarboxylic acid, an aliphatic dicarboxylic acid, or an oligomer having a carboxyl group at both ends thereof.

Incidentally, specifically, R, R', R", and R'" are derived from a diamine raw material and a dicarboxylic acid raw material as described later.

Also, a weight average molecular weight of the phenolic hydroxyl group-containing polybutadiene-modified polyamide resin (C) is preferably from 60,000 to 250,000, and more preferably from 80,000 to 200,000.

Here, the primer layer for plating process of the present invention is present in a semi-cured state (so-called B-stage state) on a support, a prepreg, or the like before it is processed as a part of layers of a laminate for wiring board or a multilayer wiring board. Also, the terms "for plating process" as referred to in the present invention mean an application for providing a plated layer (preferably an electroless copper plated layer) on a surface of the formed primer layer for plating process.

The components (A) to (C) are hereunder described.

### <Component (C)>

In the resin composition for primer layer, a blending proportion of the component (C) is 5 parts by mass or more and less than 25 parts by mass based on 100 parts by mass of a total sum of the component (A) and the component (B). So far as the component (C) is blended in this proportion, a favorable adhesive strength to plated copper is obtained while keeping favorable heat resistance.

Though reasons why such an effect is obtained are not always elucidated yet, the following reasons may be considered.

That is, since the phenolic hydroxyl group-containing polybutadiene-modified polyamide resin as the component (C) is possible to react with the epoxy resin, it is possible to make the resin tough while keeping favorable heat resistance of the epoxy resin. Furthermore, since the phenolic hydroxyl group-containing polybutadiene-modified polyamide resin as the component (C) contains a lot of amide groups having high adhesiveness to copper, a high adhesive force to plated copper is obtained.

Also, the phenolic hydroxyl group-containing polybutadiene-modified polyamide resin contains a phenolic hydroxyl group having good compatibility with the epoxy resin and polybutadiene which is incompatible with the epoxy resin, and therefore, in the case where its blending proportion is 5 parts by mass or more and less than 25 parts by mass based on 100 parts by mass of a total sum of the component (A) and the component (B), a fine sea-island structure can be formed. In view of the fact that this sea-island structure is formed, it is possible to form a minute shape at the time of roughening treatment by utilizing the matter that a sea layer and an island layer differ in a roughening amount from each other at the time of roughening treatment. Though this shape is fine, it is uniform, and therefore, a high physical adhesive force to be caused due to an anchor effect is revealed, and the adhesiveness to plated copper is conspicuously enhanced.

In the case where the blending proportion of the component (C) is less than 5 parts by mass, a domain size of the sea-island structure is large, so that Ra becomes large after the roughening treatment. Also, toughness of the resin is low; furthermore, a minute roughened shape is not obtained; and the adhesive force to plated copper is lowered.

On the other hand, in the case where the blending proportion of the component (C) is 25 parts by mass or more, for a reason that a domain size of the sea-island structure is too small and other reason, though a proportion of the amide group having high adhesiveness to copper increases, the adhesive force by an anchor effect to be caused due to the fine shape is lowered. Therefore, as a result, the adhesive force to electroless plated copper is lowered. Also, the heat resistance is lowered, and tolerance to chemicals at the time of roughening step is lowered.

Taking into consideration the matter of obtaining favorable adhesiveness to plated copper, the blending proportion of the component (C) is preferably 8 parts by mass or more and less than 25 parts by mass, more preferably 10 parts by mass or more and less than 25 parts by mass, and still more preferably 10 parts by mass or more and less than 20 parts by mass based on 100 parts by mass of a total sum of the component (A) and the component (B).

Incidentally, a phenolic hydroxyl group-containing polyamide resin or a phenolic hydroxyl group-containing acrylonitrile-butadiene-modified polyamide resin has good compatibility with the epoxy resin as compared with the phenolic hydroxyl group-containing polybutadiene-modified polyamide resin. Therefore, the sea-island structure becomes excessively minute, so that it is difficult to form a fine shape after the roughening treatment, and an adhesive force to plated copper comparable to that of the phenolic hydroxyl group-containing polybutadiene-modified polyamide resin cannot be revealed.

Also, when a nitrile group is introduced, a coefficient of moisture absorption becomes high, and insulating properties at the time of moisture absorption are lowered. As for the adhesiveness to the prepreg in a B-stage state, since the primer layer and the prepreg are possible to react with each other, firm adhesion can be secured. But, in the case where a large amount of the resin in the prepreg moves into the primer layer, there is a possibility that the domain size of the sea-island structure in the primer resin cannot be controlled, or that the adhesiveness between the primer layer and copper is deteriorated. Therefore, it is necessary to control the B-stage state of the primer layer.

The phenolic hydroxyl group-containing polybutadiene-modified polyamide resin as the component (C) is, for example, synthesized by subjecting a diamine, a phenolic hydroxyl group-containing dicarboxylic acid, a dicarboxylic acid not containing a phenolic hydroxyl group, and polybutadiene having a carboxyl group at both ends thereof to polycondensation between a carboxyl group and an amino group in an organic solvent such as N-methyl-2-pyrrolidone (NMP) in the presence of a phosphorous acid ester and a pyridine derivative as catalysts.

In the present invention, the diamine (diamine raw material) which is used for manufacture of the phenolic hydroxyl group-containing polybutadiene-modified polyamide may be any of an aromatic diamine or an aliphatic diamine.

Specific examples of the aromatic diamine include diaminobenzene, diaminotoluene, diaminophenol, diaminodimethylbenzene, diaminomesitylene, diaminonitrobenzene, diaminodiazobenzene, diaminonaphthalene, diaminobiphenyl, diaminodimethoxybiphenyl, diaminodiphenyl ether, diaminodimethyldiphenyl ether, methylenediamine, methylenebis(dimethylaniline), methylenebis(methoxyaniline), methylenebis(dimethoxyaniline), methylenebis(ethylaniline), methylenebis(diethylaniline), methylenebis(ethoxyaniline), methylenebis(diethoxyaniline), isopropylidenedianiline, diaminobenzophenone, diaminodimethylbenzophenone, diaminoanthraquinone, diaminodiphenyl thioether, diaminodimethyldiphenyl thioether, diaminodiphenylsulfone, diaminodiphenyl sulfoxide, and diaminofluorene.

Specific examples of the aliphatic diamine include ethylenediamine, propanediamine, hydroxypropanediamine, butanediamine, heptanediamine, hexanediamine, diaminodiethylamine, diaminopropylamine, cyclopentanediamine, cyclohexanediamine, azapentanediamine, and triazaundecadiamine. These aromatic diamines and aliphatic diamines may be used alone or in admixture of two or more kinds thereof.

In the present invention, examples of the phenolic hydroxyl group-containing dicarboxylic acid which is used for manufacture of the phenolic hydroxyl group-containing polybutadiene-modified polyamide include hydroxyisophthalic acid, hydroxyphthalic acid, hydroxyterephthalic acid, dihydroxyisophthalic acid, and dihydroxyterephthalic acid. However, it should not be construed that the present invention is limited thereto.

In the present invention, the dicarboxylic acid (dicarboxylic acid raw material) which is used for manufacture of the phenolic hydroxyl group-containing polybutadiene-modified polyamide may be any of an aromatic dicarboxylic acid, an aliphatic dicarboxylic acid, or an oligomer having a carboxyl group at both ends thereof. Specific examples of the aromatic dicarboxylic acid include phthalic acid, isophthalic acid, terephthalic acid, biphenyldicarboxylic acid, methylenedibenzoic acid, thiodibenzoic acid, carbonyldibenzoic acid, sulfonylbenzoic acid, and naphthalenedicarboxyl acid.

Examples of the aliphatic dicarboxylic acid include oxalic acid, malonic acid, methylmalonic acid, succinic acid, glutaric acid, adipic acid, maleic acid, fumaric acid, malic acid, tartaric acid, (meth)acryloyloxysuccinic acid, di(meth)acryloyloxysuccinic acid, (meth)acryloyloxymalic acid, (meth)acrylamidosuccinic acid, and (meth)acrylamidomalic acid.

The polybutadiene having a carboxyl group at both ends thereof is preferably an oligomer having a number average molecular weight of from 200 to 10,000, and preferably from 500 to 5,000.

Examples of commercially available products of the phenolic hydroxyl group-containing polybutadiene-modified polyamide resin (C) include BPAM-155, manufactured by Nippon Kayaku Co., Ltd.

### <Component (A) >

The polyfunctional epoxy resin as the component (A) is an epoxy resin having two or more epoxy groups in a molecule thereof, and examples thereof include a phenol novolak type epoxy resin, a cresol novolak type epoxy resin, and an aralkyl type epoxy resin. Above all, an aralkyl novolak type epoxy resin or a resin including an aralkyl novolak type epoxy resin is preferable as the polyfunctional epoxy resin.

The aralkyl novolak type epoxy resin is preferably an aralkyl novolak type epoxy resin having a biphenyl structure. The aralkyl novolak type epoxy resin having a biphenyl structure as referred to herein means an aralkyl novolak type epoxy resin having an aromatic ring of a biphenyl derivative in a molecule thereof, and examples thereof include an epoxy resin represented by the following formula (1) (in the formula, p represents from 1 to 5).

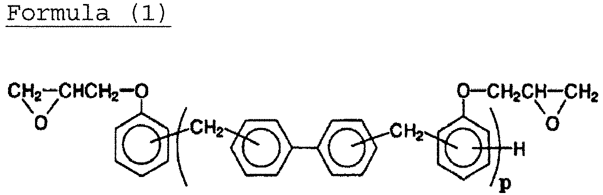

The epoxy resin represented by the foregoing formula (1) may be used in combination of plural kinds thereof.

Incidentally, examples of commercially available products of the subject resin include NC-3000 (an epoxy resin represented by the formula (1) wherein p is 1.7) and NC-3000-H (an epoxy resin represented by the formula (1) wherein p is 2.8), all of which are manufactured by Nippon Kayaku Co., Ltd.

A blending amount of the polyfunctional epoxy resin (A) is preferably from 20 to 80 % by mass, and more preferably from 40 to 70 % by mass in terms of a proportion in the resin composition for primer layer. So far as the blending amount of the component (A) falls within the range of from 20 to 80 % by mass, the adhesive strength to a circuit conductor and the solder heat resistance can be made favorable.

### <Component (B)>

As the epoxy resin curing agent as the component (B), various phenol resins, acid anhydrides, amines, hydrazides, and the like can be used. As the phenol resin, a novolak type phenol resin, a resole type phenol resin, and the like can be used. As the acid anhydride, phthalic anhydride, benzophenonetetracarboxylic acid dianhydride, methyl himic anhydride, and the like can be used. As the amine, dicyandiamide, diaminodiphenylmethane, guanylurea, and the like can be used. For the purpose of enhancing the reliability, the epoxy resin curing agent is preferably a novolak type phenol resin.

A blending amount of the epoxy resin curing agent is preferably from 0.5 to 1.5 equivalents to the epoxy group. So far as the blending amount of the epoxy resin curing agent falls within the range of from 0.5 to 1.5 equivalents to the epoxy group, not only a lowering of the adhesiveness to the external layer copper can be prevented from occurring, but a lowering of Tg (glass transition temperature) or insulating properties can be prevented from occurring.

Also, in addition to the curing agent, a reaction accelerator can be used, if desired. As the reaction accelerator, various imidazoles and BF₃ amine complexes which are a latent thermosetting agent can be used. From the standpoints of storage stability of the resin composition for primer layer and handling properties and solder heat resistance of the resin composition for primer layer in a B-stage state (semi-cured state), 2-phenylimidazole and 2-ethyl-4-methylimidazole are preferable. A blending amount thereof is preferably from 0.1 to 5.0 % by mass relative to the blending amount of the epoxy resin.

The resin composition for primer layer may contain (D) an inorganic filler (hereinafter also referred to as "component (D)") having an average primary particle diameter of not more than 100 nm. When the resin composition for primer layer contains the component (D), laser processability can be enhanced. The component (D) is hereunder described.

### <Component (D) >

Examples of the inorganic filler as the component (D) include silica, alumina, barium sulfate, talc, clay, mica powder, aluminum hydroxide, magnesium hydroxide, calcium carbonate, magnesium carbonate, magnesium oxide, boron nitride, aluminum borate, barium titanate, strontium titanate, calcium titanate, bismuth titanate, titanium oxide, barium zirconate, and calcium zirconate. Above all, fumed silica is preferable.

From the viewpoint of forming a fine wiring on an interlayer insulating layer, the inorganic filler preferably has a specific surface area of 20 m²/g or more. Also, from the viewpoint of making the surface shape after the roughening treatment in a plating process small, the average primary particle diameter is preferably not more than 100 nm.

Incidentally, the "average primary particle diameter" as referred to herein does not mean an average diameter of aggregated particles, namely it does not mean a secondary particle diameter, but it means an average particle diameter of a non-aggregated single substance. The average primary particle diameter can be, for example, determined by measurement using a laser diffraction type particle size distribution analyzer.

Furthermore, for the purpose enhancing the moisture resistance, the inorganic filler is preferably subjected to a surface treatment with a surface treating agent such as a silane coupling agent; and for the purpose of enhancing the dispersibility, the inorganic filler is preferably subjected to a hydrophobilization treatment.

A content of the component (D) is preferably not more than 10 % by mass in the resin composition for primer layer. So far as the content of the component (D) is not more than 10 % by mass, the favorable surface shape after the roughening treatment can be kept, and lowerings of plating characteristics and interlayer insulating reliability can be prevented from occurring.

Examples of commercially available products of the inorganic filler having an average primary particle diameter of not more than 100 nm include AEROSIL R972 (a trade name) and AEROSIL R202 (a trade name), all of which are manufactured by Nippon Aerosil Co., Ltd.; and PL-1 (a trade name, specific surface area: 181 m²/g) and PL-7 (a trade name, specific surface area: 36 m²/g), all of which are manufactured by Fuso Chemical Co., Ltd.).

The above-described inorganic filler may be used alone or in combination of two or more kinds thereof.

Also, for the purpose of enhancing the dispersibility, such an inorganic filler may be submitted to the use by an already-known kneading/dispersing method using a kneader, a ball mill, a bead mill, a three-roll mill, a Nanomizer, or the like.

The resin composition for primer layer in the present invention is obtained by blending the above-described essential components (A) to (C), and besides, the component (D) and various additives which are used for usual resin compositions, such as a thixotropic agent, a surfactant, and a coupling agent can be properly blended. The resin composition for primer layer can be obtained by thoroughly stirring these components and then allowing the mixture to stand until foams disappear.

It is preferable that the resin composition for primer layer in the present invention is mixed and diluted with or dispersed in a solvent to form a varnish from the standpoint of workability. For this solvent, methyl ethyl ketone, xylene, toluene, acetone, ethylene glycol monoethyl ether, cyclohexanone, ethylethoxy propionate, N,N-dimethylformamide, N,N-dimethylacetamide, N-methyl-2-pyrrolidone, and the like can be used. These solvents may be used alone or in admixture thereof.

A proportion of the solvent to the resin composition for primer layer may be properly adjusted in conformity with facilities for forming a coating film of the resin composition for primer layer. It is preferable to adjust the use amount of the solvent such that a solid content of the resin composition excluding the solvent is from 8 to 40 % by mass in the varnish.

The primer layer for plating process of the present invention is obtained by coating the resin composition for primer layer (or the varnish containing the same) on a support film or a prepreg and then drying at from 100 to 230 °C for about 1 to 10 minutes.

As the support film which is used, a non-roughened copper foil which is not roughened; a lowly roughened copper foil having a surface roughness (Ra) of not more than 0.4 µm; and on the assumption that the primer resin is coated on a glossy surface, a general copper foil, a polyethylene terephthalate film, a polyethylene naphthalate film, a polyphenylene sulfide film, a TEFLON (registered trademark) film, a polyimide film, an aluminum foil, and the like are preferable. Also, as such a support film, for the purpose of making release from the primer layer easy, one whose surface has been subjected to a release treatment may be used.

Here, in the case where the primer layer for plating process of the present invention is allowed to react with the prepreg in a B-stage state or the like, it is important to control its degree of curing. The degree of curing can be measured by a rate of reaction measured by a differential scanning calorimeter. Specifically, it is necessary that the rate of reaction of the primer layer for plating process is from 50 to 99 %. So far as the rate of reaction is 50 % or more, the incorporation of an adhesive auxiliary layer into the prepreg during lamination and curing can be prevented from occurring. So far as the rate of reaction is not more than 99 %, the matter that the adhesive force to the interface with the prepreg is lowered, resulting in a lowering of the adhesive force to the plated copper can be prevented from occurring.

The prepreg is not particularly limited so far as it is one to be used for a wiring board. For example, the prepreg is obtained by mixing a polyfunctional epoxy resin, an epoxy resin curing agent, a curing accelerator, a solvent, and optionally an inorganic filler and impregnating the mixture in a glass cloth for laminate, followed by drying. Examples of commercially available products of the prepreg include GEA-67N, GEA-679F, and GEA-679GT, all of which are manufactured by Hitachi Chemical Co., Ltd.

Also, in the case where the primer layer for plating process of the present invention is applied to a laminate for wiring board or a multilayer wiring board as described later, its surface is subjected to a roughening treatment. A surface roughness (Ra) of the primer layer after this roughening treatment is preferably not more than 0.4 µm, and more preferably not more than 0.3 µm. So far as the surface roughness (Ra) is not more than 0.4 µm, the primer layer can be allowed to cope with a high density of semiconductor packages.

Incidentally, as a condition of the roughening treatment, a roughening treatment condition as described later can be applied.

### [Laminate for wiring board provided with primer layer for plating process and method for manufacture thereof, and multilayer wiring board provided with primer layer for plating process and method for manufacture thereof]

A first laminate for wiring board provided with a primer layer for plating process of the present invention is manufactured by superimposing a primer layer-provided support film having the primer layer for plating process of the present invention on a support film, on both surfaces of a prepreg for wiring board such that the primer layer for plating process is located inside; further superimposing a mirror board on the outside thereof; press molding them; and after molding, removing the support film.

Also, a second laminate for wiring board provided with a primer layer for plating process of the present invention is manufactured by superimposing a primer layer-provided support film having the primer layer for plating process of the present invention on a support film, on both surfaces of a prepreg for wiring board such that the primer layer for plating process is located inside; laminating them by heating and applying a pressure by a laminator using a heat-resistant rubber sheet; after lamination, curing the laminate by heating; and removing the support film.

In the present invention, a heating temperature in the press molding is preferably from 150 to 240 °C. A pressure at the time of applying a pressure is preferably from 1.0 to 4.0 MPa. Also, a heating temperature in the laminator using a heat-resistant rubber sheet is preferably from 80 to 150 °C. A pressure at the time of applying a pressure is preferably from 0.3 to 20 MPa.

A first multilayer wiring board provided with a primer layer for plating process of the present invention is manufactured by superimposing a primer layer-provided support film having the primer layer for plating process of the present invention on a support film, on a prepreg for wiring board such that the primer layer for plating process is located inside; superimposing the laminate on both surfaces of a circuit-processed wiring board; further superimposing a mirror board on the outside thereof; press molding them; after molding, removing the support film; and successively applying a roughening treatment, an electroless plating treatment, resist formation, an electroplating treatment and the like to achieve circuit processing.

A second multilayer wiring board provided with a primer layer for plating process of the present invention is manufactured by superimposing a primer layer-provided support film having the primer layer for plating process of the present invention on a support film, on a prepreg for wiring board such that the primer layer for plating process is located inside; superimposing the laminate on both surfaces of a circuit-processed wiring board; laminating them by heating and applying a pressure by a laminator using a heat-resistant rubber sheet; after lamination, curing the laminate by heating; removing the support film; and successively applying a roughening treatment, an electroless plating treatment, resist formation, an electroplating treatment and the like to achieve circuit processing.

The circuit-processed wiring board (internal layer circuit board) is, for example, an internal layer substrate in which a first circuit layer (internal layer wiring) is formed on a surface thereof. The internal layer substrate is not particularly limited, and known laminates which are used for usual wiring boards, for example, glass cloth-epoxy resin, paper-phenol resin, paper-epoxy resin, glass cloth/glass paper-epoxy resin, etc., can be used. Also, a BT substrate having a bismaleimide-triazine resin impregnated therein, a polyimide film substrate using a polyimide film as a base material, and the like can be used.

As for a method for forming a circuit, in addition to a semi-additive method for forming a circuit using the foregoing plating process, known methods for manufacture of wiring boards, such as a subtractive method in which a copper-cladded laminate obtained by using a copper foil as a carrier and sticking the carrier copper foil and an insulating substrate to each other is used, and an unnecessary portion of the copper foil is removed by means of etching; and an additive method in which a circuit is formed in a necessary portion of an insulating substrate by means of electroless plating, can be adopted.

If desired, a method for subjecting the surface of the circuit layer to a surface treatment in a state adaptive to the adhesiveness is not particularly limited.

A known manufacture method, for example, a method in which an acicular crystal of copper oxide is formed on a surface of a circuit layer with an alkaline aqueous solution of sodium hypochlorite, and the formed acicular crystal of copper oxide is reduced by dipping in a dimethylamine borane aqueous solution, etc., can be adopted.

In the case of performing circuit processing on the primer layer for plating process of the laminate or multilayer wiring board of the present invention by a plating method, a roughening treatment is first performed. As a roughening solution in that case, an acidic roughening solution such as a chromium/sulfuric acid roughening solution, an alkaline permanganate roughening solution, a sodium fluoride/chromium/sulfuric acid roughening solution, and a fluoroboric acid roughening solution can be used. As for the roughening treatment, for example, an aqueous solution of diethylene glycol monobutyl ether and NaOH as a swelling solution is first heated at 70 °C, and a laminate or a multilayer wiring board is then subjected to a dipping treatment therewith for 5 minutes. Subsequently, an aqueous solution of KMnO and NaOH as a roughening solution is heated at 80 °C, and the thus-treated laminate or multilayer wiring board is subjected to a dipping treatment therewith for 10 minutes. Subsequently, the resulting laminate or multilayer wiring board is neutralized by a dipping treatment with a neutralizing solution, for example, a hydrochloric acid aqueous solution of stannous chloride (SnCl₂), at room temperature for 5 minutes.

After the roughening treatment, a plating catalyst imparting treatment for attaching palladium is performed. The plating catalyst treatment is performed by dipping in a palladium chloride based plating catalyst solution. Subsequently, an electroless plating treatment for dipping in an electroless plating solution to deposit an electroless plated layer (conductor layer) having a thickness of from 0.3 to 1.5 µm on the entire surface of the primer layer for plating process is performed.

Subsequently, a plating resist is formed, and an electroplating treatment is then performed to form a circuit having a desired thickness in a desired portion. The electroless plating solution which is used for the electroless plating treatment is not particularly limited, and known electroless plating solutions can be used. The plating resist is not particularly limited, too, and known plating resists can be used. Also, the electroplating treatment is not particularly limited, and known methods can be adopted. Such a plating is preferably a copper plating. Furthermore, by removing the electroless plated layer in an unnecessary portion by means of etching, an external layer circuit can be formed.

Then, by repeating the same steps, a multilayer wiring board having a large number of layers can be manufactured.

### EXAMPLES

Next, the present invention is specifically described by reference to the following Examples, but it should not be construed that the scope of the present invention is limited to these Examples.

### [Preparation of resin varnish for primer layer for plating process]

### (Preparation Example 1)

6.75 g of N,N-dimethylacetamide (DMAc) was blended with 0.75 g of a phenolic hydroxyl group-containing polybutadiene-modified polyamide (a trade name: BPAM-155, manufactured by Nippon Kayaku Co., Ltd.) as the component (C) ; 10 g of a biphenyl aralkyl type epoxy resin (a trade name: NC-3000H, manufactured by Nippon Kayaku Co., Ltd.) as the component (A), 4.1 g of a cresol novolak type phenol resin (a trade name: KA-1165, manufactured by DIC Corporation) as the component (B), and 0.1 g of 2-phenylimidazole (a trade name: 2PZ, manufactured by Shikoku Chemicals Corporation) as a curing accelerator were then added; and thereafter, the mixture was diluted with a mixed solvent consisting of DMAc and methyl ethyl ketone, thereby obtaining a resin varnish A for primer layer for plating process (solid content concentration: about 25 % by mass).

### (Preparation Example 2)

13.5 g of N,N-dimethylacetamide (DMAc) was blended with 1.5 g of a phenolic hydroxyl group-containing polybutadiene-modified polyamide (a trade name: BPAM-155, manufactured by Nippon Kayaku Co., Ltd.) as the component (C) ; 10 g of a biphenyl aralkyl type epoxy resin (a trade name: NC-3000H, manufactured by Nippon Kayaku Co., Ltd.) as the component (A), 3.6 g of a novolak type phenol resin (a trade name: TD-2090, manufactured by DIC Corporation) as the component (B), 0.1 g of 2-phenylimidazole (a trade name: 2PZ, manufactured by Shikoku Chemicals Corporation) as a curing accelerator, and 0.9 g of fumed silica (a trade name: R972, manufactured by Nippon Aerosil Co., Ltd.) were then added; and thereafter, the mixture was diluted with a mixed solvent consisting of DMAc and methyl ethyl ketone (solid content concentration: about 25 % by mass). Thereafter, a uniform resin varnish B for primer layer for plating process was obtained using a disperser (a trade name: NANOMIZER, manufactured by Yoshida Kikai Co., Ltd.).

### (Preparation Example 3)

A resin varnish C for primer layer for plating process (solid content concentration: about 25 % by mass) was obtained in the same manner as that in Preparation Example 2, except that the epoxy resin curing agent as the component (B) was changed to bisphenol A novolak (a trade name: YLH129, manufactured by Mitsubishi Chemical Corporation), and the components were blended in an amount shown in Table 1.

### (Preparation Examples 4 and 6)

Each of resin varnishes D and F for primer layer for plating process (solid content concentration: about 25 % by mass) was obtained in the same manner as that in Preparation Example 2, except that the epoxy resin curing agent as the component (B) was changed to cresol novolak (KA1165), and the components were blended in an amount shown in Table 1.

### (Preparation Example 5)

A resin varnish E for primer layer for plating process (solid content concentration: about 25 % by mass) was obtained in the same manner as that in Preparation Example 2, except that the epoxy resin curing agent as the component (B) was changed to phenol novolak (TD-2090), and the components were blended in an amount shown in Table 1.

### (Preparation Example 7)

A resin varnish G for primer layer for plating process (solid content concentration: about 25 % by mass) was obtained in the same manner as that in Preparation Example 2, except that a phenolic hydroxyl group-containing polybutadiene-acrylonitrile-modified polyamide (a trade name: BPAM-01, manufactured by Nippon Kayaku Co., Ltd.) was used in place of the phenolic hydroxyl group-containing polybutadiene-modif ied polyamide as the component (C), and the components were blended in an amount shown in Table 1.

**Table 1**

| | Resin varnish for primer layer for plating process | | | | | | |
|---|---|---|---|---|---|---|---|
| | A | B | C | D | E | F | G |
| Component (A) | 67 | 62 | 55 | 57 | 64 | 52 | 66 |
| Component (B) | 27 | 22 | 21 | 23 | 26 | 23.5 | 19 |
| Component (C) | 5 | 9.3 | 10.5 | 14 | 3.5 | 19 | - |
| 'Phenolic hydroxyl group-containing acrylonitrile-butadiene-modified polyamide | - | - | - | - | - | - | 9.4 |
| Curing accelerator | 1 | 0.6 | 0.5 | 0.5 | 0.5 | 0.5 | 0.6 |
| Fumed silica | - | 6 | 12 | 5.5 | 6 | 5 | 5 |
| Proportion of the component (C) based on 100 parts by mass of a total sum of the component (A) and the component (B) | 5 | 11 | 14 | 18 | 4 | 25 | 11 |

| | | | | | | | |
|---|---|---|---|---|---|---|---|
| Unit: parts by mass | | | | | | | |

### (Example 1)

The resin varnish obtained in Preparation Example 1 was coated in a thickness after drying of 5 µm on an M surface (roughening-treated surface, surface roughness (Ra): 0.2 µm) of an electrolytic copper foil having a thickness of 18 µm (FO-WS-18, low-profile copper foil, manufactured by Furukawa Electric Co., Ltd.) by using a bar coater, followed by drying at 180 °C for 10 minutes to form a primer layer for plating process.

Four sheets of a prepreg for wiring board (a trade name: GEA-679F, manufactured by Hitachi Chemical Co., Ltd., thickness: 0.10 mm) were superimposed; the primer layer for plating process was superimposed on the top and bottom thereof such that the copper foil was located outside; a mirror board and a cushion paper were further superimposed; and the laminate was cured by heating at 3.0 MPa and 180 °C for one hour by using a pressing machine. After cooling, the copper foil was separated to obtain a laminate provided with a primer layer for plating process.

For the purpose of chemically roughening this laminate provided with a primer layer for plating process, an aqueous solution containing 200 mL/L of diethylene glycol monobutyl ether and 5 g/L of NaOH was fabricated as a swelling solution and heated at 70 °C, and the laminate was subjected to a dipping treatment therewith for 5 minutes. Subsequently, an aqueous solution containing 60 g/L of KMnO₄ and 40 g/L of NaOH was fabricated as a roughening solution and heated at 80 °C, and the laminate was subjected to a dipping treatment therewith for 10 minutes. Subsequently, the thus-treated laminate was neutralized by a dipping treatment with an aqueous solution as a neutralizing solution (SnCl₂: 30 g/L, HCl: 300 mL/L) at room temperature for 5 minutes.

For the purpose of forming a circuit layer on the laminate provided a primer layer for plating process, first of all, the laminate was subjected to a dipping treatment with HS-202B (manufactured by Hitachi Chemical Co., Ltd.) as a catalyst for electroless plating containing PdCl₂ at room temperature for 10 minutes, washed with water, dipped in a plating solution CUST-201 (manufactured by Hitachi Chemical Co., Ltd.) for electroless copper plating at room temperature for 15 minutes, and then further subjected to electrolytic plating with copper sulfate. Thereafter, annealing was performed at 180 °C for 60 minutes to form a conductor layer having a thickness of 35 µm.

Subsequently, for the purpose of removing an unnecessary portion of the plated conductor by means of etching, an oxide surface film on the copper surface was first removed by means of #600 buff roll polishing; an etching resist was then formed; subsequently, etching was performed; and thereafter, the etching resist was removed to achieve circuit formation, thereby fabricating a multilayer wiring board provided with a primer layer for plating process.

### (Examples 2 to 4 and Comparative Examples 1 to 3)

Laminates provided with a primer layer for plating process and multilayer wiring boards provided with a primer layer for plating process were fabricated in the same manner as that in Example 1, except for using the resin varnishes B to G obtained in Preparation Examples 2 to 7, respectively.

### (Example 5)

A laminate provided with a primer layer for plating process and a multilayer wiring board provided with a primer layer for plating process were fabricated in the same manner as that in Example 2, except that a release-treated polyethylene terephthalate (PET) film (PET-38X, manufactured by Lintec Corporation) was used in place of the electrolytic copper foil of Example 2 (the M surface of Example 2 became the release-treated surface of the PET film).

With respect to the thus fabricated multilayer wiring boards, tests for an adhesive strength to external layer circuit, a surface roughness of primer layer for plating process, and solder heat resistance at 288 °C were carried out in the following manners. Results thereof are shown in Tables 2 to 3.

### [Adhesive strength to external layer circuit]

In a part of the circuit layer of the multilayer wiring board obtained in each of the Examples and Comparative Examples, a portion having a width of 10 mm and a length of 100 mm was formed by en etching treatment of copper; one end thereof was peeled at a circuit layer/resin interface and grasped by a grasping tool; and a load at the time of peeling in a vertical direction at a drawing rate of about 50 mm/min at room temperature was measured.

### [Surface roughness of insulating resin]

With respect to a surface of an insulating resin which was obtained by subjecting a part of the circuit layer of the multilayer wiring board obtained in each of the Examples and Comparative Examples to an etching treatment of copper, a surface roughness Ra was measured using MICROMAP MN5000 Model, manufactured by Ryoka Systems Inc.

### [Solder heat resistance at 288 °C]

The multilayer wiring board fabricated in each of the Examples and Comparative Examples was cut in a size of 25 mm square and floated on a solder bath regulated at 288 ± 2 °C, thereby examining a time until swelling occurred.

**Table 2**

| Item | Unit | Example 1 | Example 2 | Example 3 | Example 4 | Example 5 |
|---|---|---|---|---|---|---|
| Kind of varnish | | A | B | C | D | B |
| Adhesive strength | kN/m | 0.74 | 0.82 | 0.89 | 0.94 | 0.81 |
| Ra | µm | 0.35 | 0.28 | 0.24 | 0.20 | 0.26 |
| Solder heat resistance | s | >600 | >600 | >600 | >600 | >600 |

**Table 3**

| Item | Unit | Comparative Example 1 | Comparative Example 2 | Comparative Example 3 |
|---|---|---|---|---|
| Kind of varnish | | E | F | G |
| Adhesive strength | kN/m | Peeled | 0.97 | 0.44 |
| Ra | µm | 0.41 | 0.18 | 0.16 |
| Solder heat resistance | s | - | 280 | 180 |

## Claims

1. A primer layer, which is suitable for a for plating process and is formed of a resin composition comprising
(A) a polyfunctional epoxy resin,
(B) an epoxy resin curing agent, and
(C) 5 to < 25 pbw, per 100 pbw of the total of the resin (A) and the curing agent (B), of a phenolic hydroxyl group-containing polybutadiene-modified polyamide resin having structural units of formulae (i)-(iii): 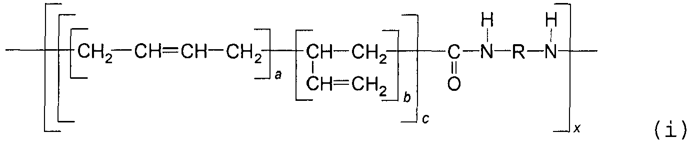 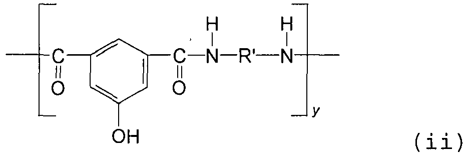 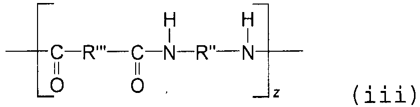 wherein
*a, b, c, x, y,* and *z* each represent an average degree of polymerization; *a* is an integer of 2-10; *b* is an integer of 0-3; *c* is an integer of 3-30; when *x* is 1, then (*y+z*) is an integer of 2-300; when *y* is 1, then *z* is 20 or more;
R, R', and R" each independently are a divalent group derived from an aromatic diamine or an aliphatic diamine; and
R'" each independently is a divalent group derived from an aromatic dicarboxylic acid, an aliphatic dicarboxylic acid, or an oligomer having a carboxyl group at both ends thereof.

2. The primer layer of claim 1, which has a thickness of 1-10 µm.

3. The primer layer of claim 1 or 2, wherein the resin (A) includes an aralkyl type epoxy resin having a biphenyl structure.

4. The primer layer of any of claims 1-3, wherein the resin composition contains an inorganic filler (D) having an average primary particle diameter of ≤ 100 nm, determined by measurement using a laser diffraction type particle size distribution analyzer.

5. The primer layer of claim 4, wherein the inorganic filler (D) is fumed silica.

6. The primer layer of claim 4 or 5, wherein the inorganic filler (D) is subjected to a surface treatment.

7. The primer layer of any of claims 1-6, which, after a roughening treatment, has a surface roughness (Ra) of ≤ 0.4 µm, measured using MICROMAP MN5000 Model manufactured by Ryoka Systems Inc..

8. A method for manufacture of a laminate for wiring board, comprising
(i) superimposing a support film having the primer layer of any of claims 1-7 provided thereon on both surfaces of a prepreg for wiring board, such that the primer layer is located inside;
(ii) further superimposing a mirror board on the outside thereof; and press molding them; or
laminating them by heating and applying a pressure by a laminator using a heat-resistant rubber sheet; and curing the laminate by heating; and
(iii) removing the support film.

9. A laminate for wiring board which is obtainable by the method of claim 8.

10. A method for manufacture of a multilayer wiring board, comprising
(i) superimposing a support film having the primer layer of any of claims 1-7 provided thereon on a prepreg for wiring board, such that the primer layer is located inside;
(ii) superimposing the laminate on both surfaces of a circuit-processed wiring board;
(iii) further superimposing a mirror board on the outside thereof; and press molding them; or
laminating them by heating and applying a pressure by a laminator using a heat-resistant rubber sheet; and curing the laminate by heating;
(iv) removing the support film; and
(v) successively applying a roughening treatment, an electroless plating treatment, and an electroplating treatment.

11. A multilayer wiring board, which is obtainable by the method of claim 10.

## Patentansprüche

1. Primerschicht, die für ein Abscheidungsverfahren geeignet ist und aus einer Harzzusammensetzung gebildet ist, umfassend
(A) ein polyfunktionelles Epoxyharz,
(B) ein Epoxyharzhärtungsmittel und
(C) 5 bis < 25 Gewichtsteile pro 100 Gewichtsteile der Gesamtheit des Harzes (A) und des Härtungsmittels (B) an einem phenolhydroxylgruppenhaltigen polybutadienmodifizierten Polyamidharz, das strukturelle Einheiten der Formeln (i)-(ii) aufweist: 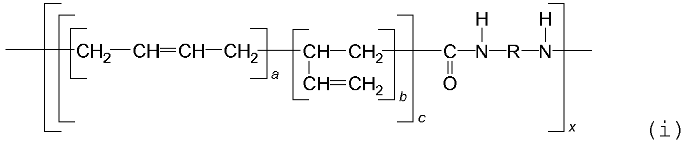 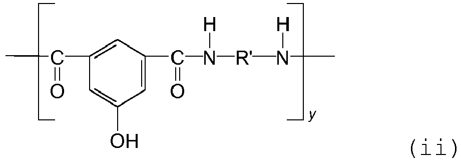 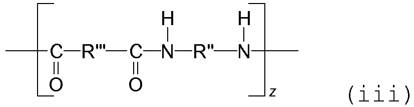 wobei
a, *b, c, x, y* und *z* jeweils einen durchschnittlichen Polymerisationsgrad darstellen; *a* eine ganze Zahl von 2-10 ist; *b* eine ganze Zahl von 0-3 ist; *c* eine ganze Zahl von 3-30 ist; wenn *x* 1 ist, dann ist (*y+z*) eine ganze Zahl von 2-300; wenn *y* 1 ist, dann ist *z* 20 oder mehr;
R, R' und R" jeweils unabhängig eine zweiwertige Gruppe sind, abgeleitet von einem aromatischen Diamin oder einem aliphatischen Diamin,
R'" jeweils unabhängig eine zweiwertige Gruppe sind, abgeleitet von einer aromatischen Dicarbonsäure, einer aliphatischen Dicarbonsäure oder einem Oligomer, das eine Carboxylgruppe an seinen beiden Enden aufweist.

2. Primerschicht gemäß Anspruch 1, die eine Dicke von 1-10 µm aufweist.

3. Primerschicht gemäß Anspruch 1 oder 2, wobei das Harz (A) ein Epoxyharz vom Aralkyltyp umfasst, das eine Biphenylstruktur aufweist.

4. Primerschicht gemäß einem der Ansprüche 1-3, wobei die Harzzusammensetzung einen anorganischen Füllstoff (D) enthält, der einen durchschnittlichen primären Partikeldurchmesser von ≤ 100 nm aufweist, bestimmt durch Messung unter Verwendung eines Partikelgrößenverteilungsanalysators vom Laserbeugungstyp.

5. Primerschicht gemäß Anspruch 4, wobei der anorganische Füllstoff (D) pyrogenes Siliciumdioxid ist.

6. Primerschicht gemäß Anspruch 4 oder 5, wobei der anorganische Füllstoff (D) einer Oberflächenbehandlung unterworfen wird.

7. Primerschicht gemäß einem der Ansprüche 1-6, die nach einer Aufrauungsbehandlung eine Oberflächenrauigkeit (Ra) von ≤ 0,4 µm aufweist, gemessen unter Verwendung von MICROMAP MN5000 Model hergestellt durch Ryoka Systems Inc.

8. Verfahren zur Herstellung eines Laminats für eine Leiterplatte, umfassend
(i) Überlagern eines Trägerfilms, auf dem die Primerschicht gemäß einem der Ansprüche 1-7 angeordnet ist, auf beiden Flächen eines Prepregs für eine Leiterplatte, sodass sich die Primerschicht innen befindet;
(ii) weiteres Überlagern einer Spiegelplatte auf der Außenseite davon; und Pressformen dieser; oder
Laminieren dieser durch Erhitzen und Anwenden eines Drucks durch einen Laminator unter Verwendung einer hitzebeständigen Kautschukfolie; und Härten des Laminats durch Erhitzen; und
(iii) Entfernen des Trägerfilms.

9. Laminat für eine Leiterplatte, das nach dem Verfahren gemäß Anspruch 8 erhältlich ist.

10. Verfahren zur Herstellung einer mehrschichtigen Leiterplatte, umfassend
(i) Überlagern eines Trägerfilms, auf dem die Primerschicht gemäß einem der Ansprüche 1-7 angeordnet ist, auf beiden Flächen eines Prepregs für eine Leiterplatte, sodass sich die Primerschicht innen befindet;
(ii) Überlagern des Laminats auf beiden Seiten einer mit Schaltung verarbeiteten Leiterplatte;
(iii) weiteres Überlagern einer Spiegelplatte auf der Außenseite davon; und Pressformen dieser; oder
Laminieren dieser durch Erhitzen und Anwenden eines Drucks durch einen Laminator unter Verwendung einer hitzebeständigen Kautschukfolie; und Härten des Laminats durch Erhitzen;
(iv) Entfernen des Trägerfilms; und
(v) sukzessives Anwenden einer Aufrauungsbehandlung, einer stromlosen Abscheidungsbehandlung und einer Galvanisierungsbehandlung.

11. Mehrschichtige Leiterplatte, erhältlich durch das Verfahren gemäß Anspruch 10.

## Revendications

1. Couche de primaire, qui convient à un processus de placage et est formée d'une composition de résines comprenant :
(A) une résine époxy polyfonctionnelle ;
(B) un agent de durcissement de résine époxy, et
(C) 5 à <25 parties en poids, pour 100 parties en poids du total de la résine (A) et de l'agent durcissant (B), d'une résine de polyamide modifiée par du polybutadiène et contenant un groupement hydroxyle phénolique ayant des unités structurelles de formules (i)-(iii) : 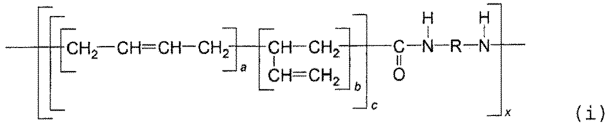 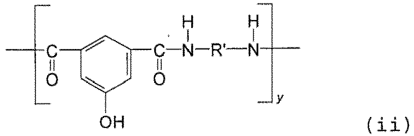 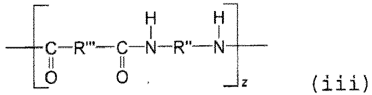 dans laquelle :
*a, b, c, x, y* et *z* représentent chacun un degré moyen de polymérisation ; *a* est un entier de 2 à 10 ; *b* est un entier de 0 à 3 ; *c* est un entier de 3 à 30 ; lorsque *x* est 1, alors *(y+z)* est un entier de 2 à 300 ; lorsque *y* est 1, alors *z* est 20 ou plus ;
R, R' et R" sont chacun indépendamment un groupement divalent tiré d'une diamine aromatique ou d'une diamine aliphatique ; et
chaque R'" est indépendamment un groupement divalent tiré d'un acide dicarboxylique aromatique, d'un acide dicarboxylique aliphatique ou d'un oligomère ayant un groupement carboxyle à ses deux extrémités.

2. Couche de primaire selon la revendication 1, qui a une épaisseur de 1 à 10 µm.

3. Couche de primaire selon la revendication 1 ou 2, dans laquelle la résine (A) inclut une résine époxy de type aralkyle ayant une structure biphénylique.

4. Couche de primaire selon l'une quelconque des revendication 1 à 3, dans laquelle la composition de résine contient une charge inorganique (D) ayant un diamètre particulaire principal moyen ≤ 100 nm, déterminé par mesure en utilisant un analyseur de distribution de taille particulaire par diffraction laser.

5. Couche de primaire selon la revendication 4, dans laquelle la charge inorganique (D) est de la silice fumée.

6. Couche de primaire selon la revendication 4 ou 5, dans laquelle la charge inorganique (D) est soumise à un traitement de surface.

7. Couche de primaire selon l'une quelconque des revendications 1 à 6, qui, après un traitement de dégrossissage, a une rugosité de surface (Ra) ≤ 0,4 µm mesurée en utilisant le modèle MICROMAP MN5000 fabriqué par Ryoka Systems Inc..

8. Procédé de fabrication d'un stratifié pour carte de circuit imprimé, comprenant :
(i) la superposition d'un film de support ayant la couche de primaire selon l'une quelconque des revendications 1 à 7 qui lui est appliquée sur les deux surfaces d'un pré-imprégné pour carte de circuit imprimé, de sorte que la couche de primaire soit située à l'intérieur ;
(ii) la superposition en outre d'une carte miroir sur sa surface externe ; et leur moulage à la presse ; ou
leur stratification par chauffage et l'application d'une pression par un dispositif de stratification en utilisant une feuille de caoutchouc thermorésistante ; et le durcissement du stratifié par chauffage ; et
(iii) le retrait du film de support.

9. Stratifié pour carte de circuit imprimé pouvant être obtenu par le procédé de la revendication 8.

10. Procédé de fabrication d'une carte de circuit imprimé multicouche comprenant :
(i) la superposition d'un film de support ayant la couche de primaire selon l'une quelconque des revendications 1 à 7 qui lui est appliquée sur un pré-imprégné pour carte de circuit imprimé de sorte que la couche primaire soit située à l'intérieur ;
(ii) la superposition du stratifié sur les deux surfaces d'une carte de circuit imprimé traité ;
(iii) la superposition en outre d'une carte miroir sur sa surface externe ; et leur moulage à la presse ; ou
leur stratification par chauffage et l'application d'une pression par un dispositif de stratification en utilisant une feuille de caoutchouc thermorésistante ; et le durcissement du stratifié par chauffage ;
(iv) le retrait du film de support ; et
(v) l'application successive d'un traitement de dégrossissage, d'un traitement de placage sans courant, et d'un traitement d'électrodéposition.

11. Carte de circuit imprimé multicouche pouvant être obtenue par le procédé de la revendication 10.
